# EUROPEAN PATENT SPECIFICATION

(11) **EP 4 318 207 B1**
(45) Date of publication and mention of the grant of the patent: **09.12.2026**
(21) Application number: 23156740.5
(22) Date of filing: 15.02.2023
(51) Int. Cl.: G06F 7/58

(54) **ENTROPY SOURCE CIRCUIT**
ENTROPIEQUELLENSCHALTUNG
CIRCUIT DE SOURCE D'ENTROPIE

(30) Priority: 04.08.2022 TW 111129255
(43) Date of publication of application: 07.02.2024
(73) Proprietor: PUFsecurity Corporation, Hsinchu County 302 (TW)
(72) Inventor: You, Chun-Heng, Hsinchu County 302 (TW); Chuang, Kai-Hsin, Hsinchu County 302 (TW); Shao, Chi-Yi, Hsinchu County 302 (TW)
(74) Representative: Straus, Alexander

(56) References cited:
- US-A1- 2011 128 081
- US-A1- 2015 178 048
- TOKUNAGA C ET AL: "True Random Number Generator with a Metastability-Based Quality Control", 2007 IEEE INTERNATIONAL SOLID-STATE CIRCUITS CONFERENCE (IEEE CAT. NO.07CH37858), IEEE, PISCATAWAY, NJ, USA, 1 February 2007 (2007-02-01), pages 404 - 611, XP031111266, ISBN: 978-1-4244-0852-8

## Description

### Field of the Invention

The present invention is related to an entropy source circuit according to claim 1.

### Background of the Invention

In current electronic systems, random number generators are typically needed for generating random numbers, which are configured to be used in security related functions. Related art random number generators generate high quality true random numbers based on circuits which inherently have randomness such as oscillators and thermal noise samplers. These circuits are analog circuits, however, making design of these circuits difficult to be integrated into an all-digital design flow.

In order to effectively reduce overall costs (e.g. human tasks, design schedules), there is a need for a novel method and associated architecture that can enable the operation of collecting randomness to be implemented with an all-digital circuit.

### Summary of the Invention

The application aims at providing an entropy source circuit, to make a design flow of the entropy source circuit capable of being integrated into an all-digital design flow, thereby improving overall manufacturing efficiency.

This is achieved by an entropy source circuit according to claim 1. The dependent claims pertain to corresponding further developments and improvements.

As will be seen more clearly from the detailed description following below, the claimed entropy source circuit comprises an input data control circuit, a digital circuit, a determination circuit and a TDC. The input data control circuit may be configured to output a start signal, input data, and reference data corresponding to the input data. The digital circuit has an input terminal and an output terminal, and the input terminal of the digital circuit may be configured to receive the input data. The determination circuit is coupled to the output terminal of the digital circuit, and may be configured to receive the reference data, wherein when an output generated on the output terminal of the digital circuit is equal to the reference data, the determination circuit generates a determination signal. In addition, the TDC is coupled to the input data control circuit and the determination circuit, and may be configured to receive the start signal and generate entropy data according to the start signal and the determination signal.

The entropy source circuit provided by the embodiments of the present invention can convert a delay of operations of a digital circuit into a digital signal. As the delay has randomness, the digital signal can also have randomness. In comparison with the related art, the present invention does not need additional analog circuits such as an oscillator or a thermal noise sampler. Thus, the design of an overall circuit of the present invention can be integrated into a digital design flow, and an overall manufacturing efficiency can be effectively improved.

### Brief Description of the Drawings

In the following, the invention is further illustrated by way of example, taking reference to the accompanying drawings. Thereof:
FIG. 1 is a diagram illustrating an entropy source circuit according to an embodiment of the present invention;
FIG. 2 is a diagram illustrating data and signals of FIG. 1 according to an embodiment of the present invention;
FIG. 3 is a diagram illustrating a detailed implementation of an entropy source circuit coupled to a digital system according to an embodiment of the present invention;
FIG. 4 is a diagram illustrating a detailed implementation of an entropy source circuit according to another embodiment of the present invention;
FIG. 5 is a diagram illustrating a detailed implementation of a time-to-digital converter according to an embodiment of the present invention;
FIG. 6 is a diagram illustrating a detailed implementation of a time-to-digital converter according to another embodiment of the present invention;
FIG. 7 is a diagram illustrating a flag signal generator according to an embodiment of the present invention; and
FIG. 8 is a diagram illustrating a working flow of a method for collecting randomness from operation time of a digital circuit according to an embodiment of the present invention.

### Detailed Description

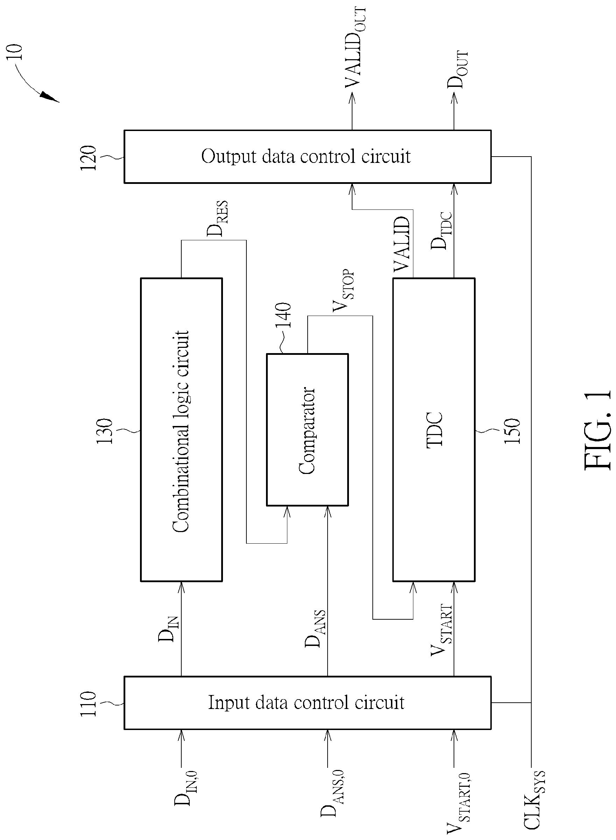

FIG. 1 is a diagram illustrating an entropy source circuit 10 according to an embodiment of the present invention. As shown in FIG. 1, the entropy source circuit 10 may comprise an input data control circuit 110, an output data control circuit 120, a digital circuit such as a combinational logic circuit 130, a determination circuit such as a comparator 140, and a time-to-digital converter (TDC) 150. In this embodiment, the input data control circuit 110 may receive input data D_{IN,0}, reference data D_{ANS,0}, external control signals such as a start signal V_{START,0} and a system clock CLK_{SYS}, and may perform timing control on the input data D_{IN,0}, the reference data D_{ANS,0} and the start signal V_{START,0}, to output input data D_{IN} and the start signal V_{START} based on timing of the system clock CLK_{SYS}. In detail, at a time point of the input data D_{IN} being transmitted to the combinational logic circuit (e.g. a time point of the system clock being pulled up), the start signal V_{START} is concurrently transmitted to the TDC 150, to make the TDC 150 determine a time point of start timing according to the start signal V_{START}.

In addition, the combinational logic circuit 130 may be configured to generate a result data D_{RES} according to the input data D_{IN}. For example, the combinational logic circuit 130 may perform a logic operation on one or more sets of sub-data within the input data D_{IN} to generate the result data D_{RES}. The reference data D_{ANS} may be arranged in advance before the input data D_{IN} is transmitted to the combinational logic circuit 130, to make the reference data D_{ANS} be equal to the result data D_{RES}, and the comparator 140 may be configured to perform determination on the reference data D_{ANS} with data output from the combinational logic circuit 130, in order to generate a determination signal such as V_{STOP}. When the combinational logic circuit 130 has not yet completed the aforementioned logic operation mentioned (e.g. a dynamic output of the combinational logic circuit 130 is not result data D_{RES}), the determination signal V_{STOP} may have a first logic value (e.g. a logic value "0"). When the combinational logic circuit 130 completes the aforementioned logic operation mentioned (e.g. the dynamic output of the combinational logic circuit 130 is equal to the result data D_{RES}), the determination signal V_{STOP} may have a second logic value (e.g. a logic value "1"). In other embodiments, the determination circuit may be implemented by other circuit components which have the function of determining "whether the reference data D_{ANS} and the result data D_{RES} are identical".

A time point of a logic value of the determination signal V_{STOP} being changed may be arranged for representing a time point of the combinational logic circuit 130 completing the aforementioned logic operation. In some embodiments, the reference data D_{ANS} may be transmitted to the comparator 140 at the same time point of transmitting the input data D_{IN} to the combinational logic circuit 130, but the present invention is not limited thereto. In other embodiments, the reference data D_{ANS} may be transmitted to the comparator 140 in advance before the time point of transmitting the input data D_{IN} to the combinational logic circuit 130, or the reference data D_{ANS} may be transmitted to the comparator 140 after the time point of transmitting the input data D_{IN} to the combinational logic circuit 130, but the present invention is not limited thereto. It should be noted that, as long as the reference data D_{ANS} can be transmitted to the comparator 140 before the combinational logic circuit 130 completes the aforementioned logic operation (e.g. before a time point of outputting the correct result data D_{RES}), the timing of the input data control circuit 110 transmitting the reference data D_{ANS} to the comparator 140 may vary.

The TDC 150 may be configured to perform time-to-digital conversion on a delay of the combinational logic circuit 130 generating the result data D_{RES} according to the input data D_{IN} with aid of the determination signal V_{STOP}, in order to generate entropy data D_{TDC} corresponding to the delay. For example, the combinational logic circuit 130 may receive the input data D_{IN} at a first time point, and the determination signal V_{STOP} may indicate that the data output from the combinational logic circuit 130 is equal to the result data D_{RES} at a second time point, where a time difference between the first time point and the second time point may represent the delay. In detail, the dynamic output of the combinational logic circuit 130 during a period between the first time point and the second time point may be invalid values, outputs generated based on previous input data (e.g. last data of D_{IN}), or a temporary erroneous result caused by delays (e.g. propagation delay or operation delay). Thus, the dynamic output of the combinational logic circuit 130 during a period between the first time point and the second time point may be different from the result data D_{ANS}, making the determination signal V_{STOP} output from the comparator 140 be the first logic value which indicates that the combinational logic circuit 130 has not yet output the correct result data D_{RES}. When the comparator 140 detects that the dynamic output of the combinational logic circuit 130 is equal to the reference data D_{ANS} at the second time point (which means the combinational logic circuit 130 has output the correct result data D_{RES}), the determination signal V_{STOP} may be pulled to the second logic value, and the TDC 150 may determine a time point of stop timing according to the determination signal V_{STOP}. In addition, the TDC 150 may utilize a flag signal VALID to indicate that the entropy data D_{TDC} is valid when the time-to-digital conversion is completed, but the present invention is not limited thereto. The output data control circuit 120 may perform timing control on the entropy data D_{TDC} and the flag signal VALID according to the system clock CLK_{SYS}, to output entropy data D_{OUT} and a flag signal VALID_{OUT} that are synchronous with the system clock CLK_{SYS}. For example, the output data control circuit 120 may generate and output the entropy data D_{OUT} and the flag signal VALID_{OUT} according to the entropy data D_{TDC} and the flag signal VALID at transition edges of the system clock CLK_{SYS}, but the present invention is not limited thereto.

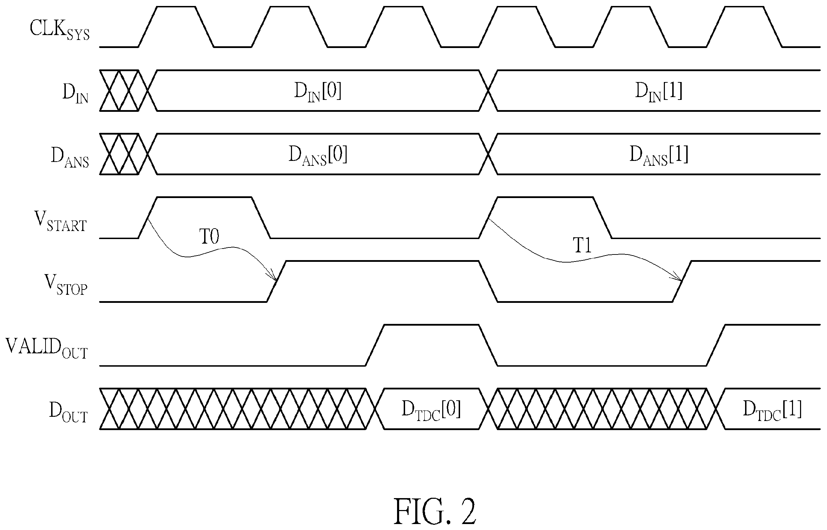

FIG. 2 is a diagram illustrating data and signals of FIG. 1 such as the system clock CLK_{SYS}, the input data D_{IN}, the reference data D_{ANS}, the start signal V_{START}, the determination signal V_{STOP}, the flag signal VALID_{OUT} and the entropy data D_{TDC} according to an embodiment of the present invention. As shown in FIG. 2, at a time point of the start signal V_{START} changing from the first logic value (e.g. the logic value "0") into the second logic value (e.g. the logic value "1"), such as a time point of a first rising edge of the start signal V_{START} shown in FIG. 2 (which may be an example of the first time point mentioned above), the input data D_{IN} may be D_{IN}[0], and the reference data D_{ANS} may be D_{ANS}[0], which means the combinational logic circuit 130 receives the input data D_{IN}[0] and starts performing the logic operation on the input data D_{IN}[0]. After a delay T0, the combinational logic circuit 130 may complete the logic operation performed on the input data D_{IN}[0] to make the result data D_{RES} be equal to the reference data D_{ANS}[0], and the determination signal V_{STOP} output from the comparator 140 may be therefore pulled to the second logic value from the first logic value to indicate that the result data D_{RES} is equal to the reference data D_{ANS}[0], where a first rising edge of the determination signal V_{STOP} shown in FIG. 2 may be an example of the second time point mentioned above. The TDC 150 may perform time-to-digital conversion on the delay T0 according to the start signal V_{START} and the determination signal V_{STOP}, in order to generate entropy data D_{TDC}[0] corresponding to the delay T0, wherein when the TDC 150 completes the time-to-digital conversion, the flag signal VALID_{OUT} may be pulled to the second logic value from the first logic value. Similarly, at a time point of a second rising edge of the start signal V_{START} (which may be another example of the first time point mentioned above), the input data D_{IN} may be D_{IN}[1] and the reference data D_{ANS} may be D_{ANS}[1], which means the combinational logic circuit 130 receives the input data D_{IN}[1] and starts performing the logic operation on the input data D_{IN}[1]. After a delay T1, the combinational logic circuit 130 may complete the logic operation performed on the input data D_{IN}[1] to make the result data D_{RES} be equal to the reference data D_{ANS}[1], and the determination signal V_{STOP} output from the comparator 140 may be therefore pulled to the second logic value from the first logic value to indicate that the result data D_{RES} is equal to the reference data D_{ANS}[1], where a second rising edge of the determination signal V_{STOP} shown in FIG. 2 may be another example of the second time point mentioned above. The TDC 150 may perform time-to-digital conversion on the delay T1 according to the start signal V_{START} and the determination signal V_{STOP}, in order to generate entropy data D_{TDC}[1] corresponding to the delay T1, wherein when the TDC 150 completes the time-to-digital conversion, the flag signal VALID_{OUT} may be pulled to the second logic value from the first logic value.

It should be noted that a delay of any logic unit (or each logic unit) within the combinational logic circuit 130 may have randomness due to the impact of noise, and a time period (e.g. the delays T0 and T1) for the logic operation performed on any input data by the combinational logic circuit 130 may also have randomness, making the entropy data D_{TDC}[0] and D_{TDC}[1] output from the TDC 150 also have randomness.

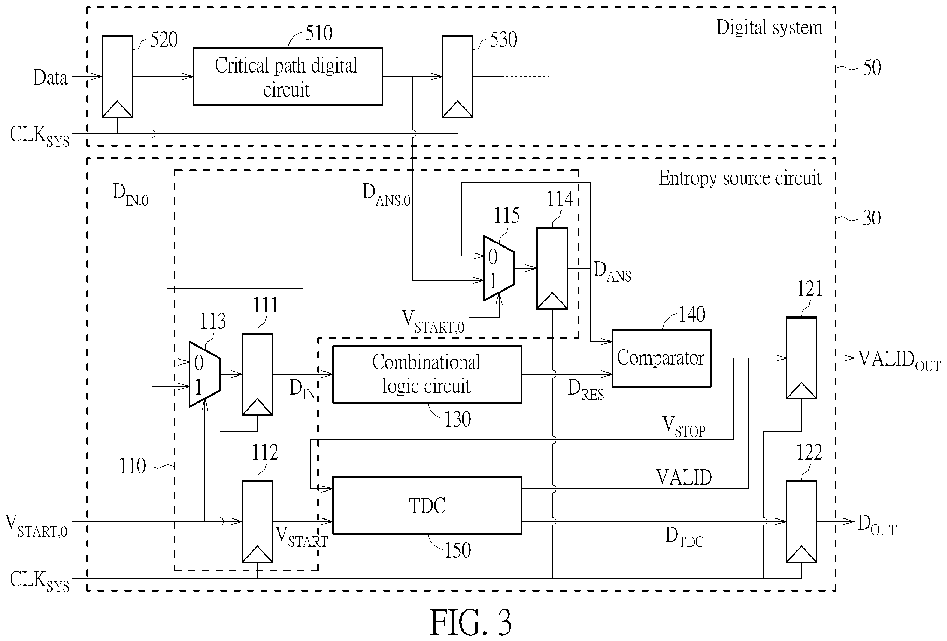

FIG. 3 is a diagram illustrating a detailed implementation of an entropy source circuit 30 coupled to a digital system 50 according to an embodiment of the present invention, where the entropy source circuit may be an example of the entropy source circuit 10 shown in FIG. 1. In this embodiment, operations of the digital system 50 may comprise multiple signal paths, where a critical path of the multiple digital signal paths is a digital signal path having a longest delay among the multiple digital signal paths, and a logic operation corresponding to the critical path is equal to the logic operation performed on the input data D_{IN} by the combinational logic circuit 130. In particular, the critical path is provided by a critical path digital circuit 510 within the digital system 50. For example, a combination of logic gates within the combinational logic circuit 130 may be identical to a combination of logic gates within the critical path digital circuit 510. As shown in FIG. 3, the input data D_{IN,0} mentioned in the embodiment of FIG. 1 may be data obtained from an input terminal of the critical path digital circuit 510 (e.g. data transmitted to the critical path digital circuit 510 from a flip-flop 520), and the reference data D_{ANS,0} mentioned in the embodiment of FIG. 1 may be data obtained from an output terminal of the critical path digital circuit 510 (e.g. result data generated to a flip-flop 530 in advance by the critical path digital circuit 510 according to the input data D_{IN,0}).

As shown in FIG. 3, in addition to the combinational logic circuit 130, the comparator 140 and the TDC 150, the entropy source circuit 30 may further comprise a flip-flop 111, a flip-flop 112 and a selector 113, where two input terminals (respectively labeled "0" and "1") of the selector 113 are respectively coupled to an output terminal of the flip-flop 111 and the input terminal of the critical path digital circuit 510, and an output terminal of the selector 113 is coupled to an input terminal of the flip-flop 111. In addition, the entropy source circuit 30 may further comprise a flip-flop 114 and a selector 115, where two input terminals (respectively labeled "0" and "1") of the selector 115 are respectively coupled to an output terminal of the flip-flop 114 and the output terminal of the critical path digital circuit 510, and an output terminal of the selector 115 is coupled to an input terminal of the flip-flop 114. The portion comprising the flip-flop 111, the flip-flop 112, the selector 113, the flip-flop 114 and the selector 115 may be an example of the input data control circuit 110 of the embodiment of FIG. 1, but the present invention is not limited thereto. In addition, the entropy source circuit 30 may further comprise flip-flops 121 and 122, where the portion comprising the flip-flops 121 and 122 may be an example of the output data control circuit 120 of the embodiment of FIG. 1, but the present invention is not limited thereto.

In this embodiment, the selector 113 may be configured to control whether to transmit data of the input terminal of the critical path digital circuit 510 (e.g. the input data D_{IN,0}) to the input terminal of the flip-flop 111 according to the start signal V_{START,0}. The flip-flop 111 may be configured to control timing of transmitting the input data D_{IN,0} to the combinational logic circuit 130 (e.g. timing of the input data D_{IN}) according to the system clock CLK_{SYS}. The flip-flop 112 may be configured to control timing of transmitting the start signal V_{START,0} to the TDC 150 (e.g. timing of the start signal V_{START}) according to the system clock CLK_{SYS}. For example, when a logic value of the start signal V_{START,0} is "0", the selector 113 may select the input data D_{IN} to be transmitted to the input terminal of the flip-flop 111, to make the value of the input data D_{IN} remain unchanged; and when the logic value of the start signal V_{START,0} is "1", the selector 113 may select the input data D_{IN,0} to be transmitted to the input terminal of the flip-flop 111, to make the value of the input data D_{IN} be updated. In addition, the selector 115 may be configured to control whether to transmit data of the output terminal of the critical path digital circuit 510 (e.g. the reference data D_{ANS,0}) to the input terminal of the flip-flop 114 according to the start signal V_{START,0}. The flip-flop 114 may be configured to control timing of transmitting the reference data D_{ANS,0} to the comparator 140 (e.g. timing of the reference data D_{ANS}) according to the system clock CLK_{SYS}. For example, when the logic value of the start signal V_{START,0} is "0", the selector 115 may select the reference data D_{ANS} to be transmitted to the input terminal of the flip-flop 114, to make a value of the reference data D_{ANS} remain unchanged; and when the logic value of the start signal V_{START,0} is "1", the selector 115 may select the reference data D_{ANS,0} to be transmitted to the input terminal of the flip-flop 114, to make the value of the reference data D_{ANS} be updated.

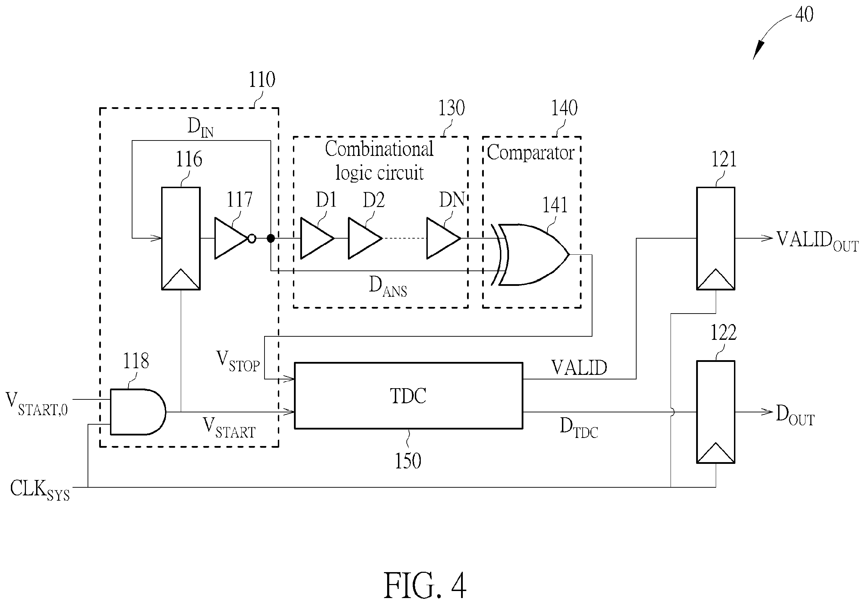

FIG. 4 is a diagram illustrating a detailed implementation of an entropy source circuit 40 according to another embodiment of the present invention, where the entropy source circuit 40 may be an example of the entropy source circuit 10 shown in FIG. 1. As shown in FIG. 4, in addition to the combinational logic circuit 130, the comparator 140 and the TDC 150, the entropy source circuit 40 may further comprise a flip-flop 116, an inverter 117 and an AND gate 118, where an input terminal of the inverter 117 is coupled to an output terminal of the flip-flop 116, and an output terminal of the inverter 117 is coupled to an input terminal of the flip-flop 116. The portion comprising the AND gate 118, the flip-flop 116 and the inverter 117 may be an example of the input data control circuit 110 mentioned in the embodiment of FIG. 1, but the present invention is not limited thereto. In this embodiment, the flip-flop 116 may be configured to update the values of the input data D_{IN} and the reference data D_{ANS} according to the start signal V_{START,0} and the system clock CLK_{SYS}. For example, the AND gate 118 may be configured to perform an AND logic operation on the start signal V_{START,0} and the system clock CLK_{SYS}, to generate a timing control signal such as the start signal V_{START}, and the flip-flop 116 may update the values of the input data D_{IN} and the reference data D_{ANS} according to the start signal V_{START}, where a logic value of the output terminal of the inverter 117 represents the values of the input data D_{IN} and the reference data D_{ANS}.

In this embodiment, the combinational logic circuit 130 may comprise multiple delay units D1, D2, ..., and DN connected in series, where an input terminal of the delay unit D1 may be an input terminal of the combinational logic circuit 130 for receiving the input data D_{IN}, and an output terminal of the delay unit DN may be an output terminal of the combinational logic circuit 130 for being coupled to the comparator 140. In this embodiment, the comparator 140 may comprise an exclusive-OR (XOR) gate 141, where a first input terminal of the XOR gate 141 is coupled to the output terminal of the combinational logic circuit 130 (e.g. the output terminal of the delay unit DN), a second input terminal of the XOR gate 141 is coupled to the output terminal of the inverter 117, and a logic value of an output terminal of the XOR gate 141 represents the determination signal V_{STOP}.

In particular, the input terminal and the output terminal of the flip-flop 116 may have different logic values, and thus the flip-flop 116 may change the logic value of the output terminal of the inverter 117 in response to a rising edge of the start signal V_{START} (i.e. changing the input data D_{IN} and the reference data D_{ANS} in response to the rising edge of the start signal V_{START}). Assume that both the input data D_{IN} and the reference data D_{ANS} are the first logic value at the beginning, and data of the output terminal of the combinational logic circuit 130 is also the first logic value, where the determination signal V_{STOP} output from the comparator 140 may therefore indicate that the data of the output terminal of the combinational logic circuit 130 is identical to the reference data D_{ANS}. When the input data D_{IN} and the reference data D_{ANS} are updated to the second logic value in response to the rising edge of the start signal V_{START}, the logic value of the determination signal V_{STOP} output from the comparator 140 may be changed to indicate that the data of the output terminal of the combinational logic circuit 130 is different from the reference data D_{ANS}. After a period of delay passes, the data of the output terminal of the combinational logic circuit 130 is updated to the second logic value in response to the change of the input data D_{IN}, where the logic value of the determination signal V_{STOP} output from the comparator 140 at this moment can be changed again to indicate that the data of the output terminal of the combinational logic circuit 130 is identical to the reference data D_{ANS}. Thus, the TDC 150 may perform the aforementioned time-to-digital conversion according to time points of the change in the logic values of the start signal V_{START} and the determination signal V_{STOP}, in order to generate the entropy data D_{TDC}. Thus, a total delay of the delay units may correspond to the entropy data D_{TDC}.

In this embodiment, when the data of the output terminal of the combinational logic circuit 130 is different from the reference data D_{ANS}, the logic value of the determination signal V_{STOP} is "1", and when the data of the output terminal of the combinational logic circuit 130 is identical to the reference data D_{ANS}, the logic value of the determination signal V_{STOP} is "0", but the present invention is not limited thereto. In some embodiments, the comparator 140 may be implemented with other combinational logic circuits, wherein when the data of the output terminal of the combinational logic circuit 130 is different from the reference data D_{ANS}, the logic value of the determination signal V_{STOP} is "0", and when the data of the output terminal of the combinational logic circuit 130 is identical to the reference data D_{ANS}, the logic value of the determination signal V_{STOP} is "1".

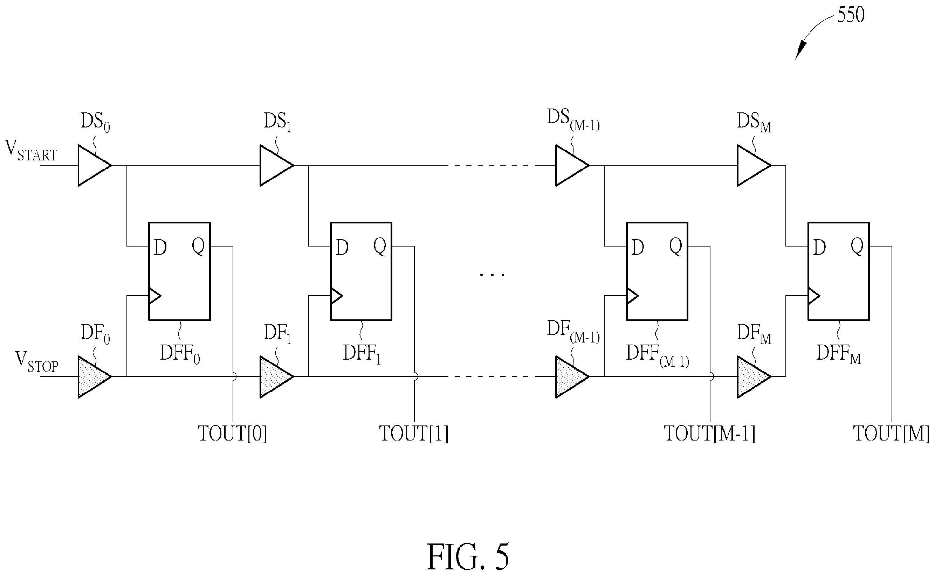

FIG. 5 is a diagram illustrating a detailed implementation of a TDC 550 according to an embodiment of the present invention, where the TDC 550 may be an example of the TDC 150 mentioned above. As shown in FIG. 5, the TDC 550 may comprise multiple delay units DS₀, DS₁, ..., DS_{(M - 1)} and DS_{M} (M is a positive integer) connected in series, where an input terminal of a first delay unit such as the delay unit D_{S0} of the delay units DS₀, DS₁, ..., DS_{(M - 1)} and DS_{M} is configured to receive the start signal V_{START}, wherein the start signal V_{START} may indicate the first time point mentioned above. The TDC 550 may further comprise multiple flip-flops such as D-type flip-flops (DFFs) DFF₀, DFF₁, ..., DFF_{(M - 1)} and DFF_{M}, where input terminals of the DFFs DFF₀, DFF₁, ..., DFF_{(M - 1)} and DFF_{M} (labeled "D" in FIG. 5) are respectively coupled to output terminals of the delay units DS₀, DS₁, ..., DS_{(M - 1)} and DS_{M}, and each DFF of the DFFs DFF₀, DFF₁, ..., DFF_{(M - 1)} and DFF_{M} transmits data of the input terminal of each aforementioned DFF to an output terminal (labeled "Q" in FIG. 5) of each aforementioned DFF at the second time point mentioned above according to the determination signal V_{STOP}, in order to output (M + 1) bits of entropy data {TOUT[0], TOUT[1], ..., TOUT[M - 1], TOUT[M]}. For example, the start signal V_{START} may be changed from the logic value "0" to the logic value "1", and the rising edge of the start signal V_{START} may be transferred, starting from the delay unit D_{S0}, to the following delay units, where when the determination signal V_{STOP} is changed from the logic value "0" to the logic value "1", the DFFs DFF₀, DFF₁, ..., DFF_{(M - 1)} and DFF_{M} may output the entropy data {TOUT[0], TOUT[1], ..., TOUT[M - 1], TOUT[M]} in response to the rising edge of the determination signal V_{STOP}. In this embodiment, a value of the entropy data {TOUT[0], TOUT[1], ..., TOUT[M - 1], TOUT[M]} is expressed in a format of a thermometer code. In addition, assume that a delay of each delay unit of the delay units DS₀, DS₁, ..., DS_{(M - 1)} and DS_{M} is T_{SLOW}, and a delay of each buffer of buffers DF₀, DF₁, ..., DF_{(M - 1)} and DF_{M} for transmitting the determination signal V_{STOP} to the DFFs DFF₀, DFF₁, ..., DFF_{(M - 1)} and DFF_{M} is T_{FAST}, where the delay T_{SLOW} is greater than the delay T_{FAST}, and resolution of the TDC 550 may be (T_{SLOW} - T_{FAST}), but the present invention is not limited thereto.

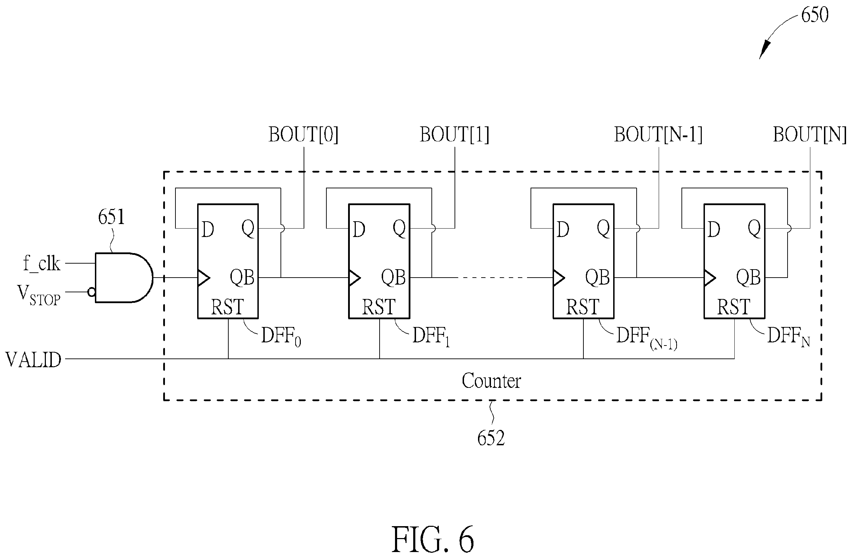

FIG. 6 is a diagram illustrating a detailed implementation of a TDC 650 according to another embodiment of the present invention, where the TDC 650 may be an example of the TDC 150 mentioned above. As shown in FIG. 6, the TDC 650 may comprise a clock control logic such as an AND gate 651, where a first input terminal of the AND gate 651 may receive a TDC clock f_clk, and a second input terminal of the AND gate 651 may receive the determination signal V_{STOP} or an inverted signal thereof. In particular, the AND gate 651 may be configured to generate a counting clock according to the TDC clock f_clk and the determination signal V_{STOP}, where the counting clock is enabled within a time interval between the first time point and the second time point only. For example, assuming that the determination signal V_{STOP} utilizes the logic value "0" for indicating that the data of the output terminal of the combinational logic circuit 130 is different from the reference data D_{ANS} and utilizes the logic value "1" for indicating that the data of the output terminal of the combinational logic circuit 130 is identical to the reference data D_{ANS}, the AND gate 651 may perform an AND logic operation on the TDC clock f_clk and the inverted signal of the determination signal V_{STOP} (which is illustrated by a circle on the second input terminal of the AND gate 651 in FIG. 6), to only make the counting clock enabled within the interval between a time point of a falling edge of the determination signal V_{STOP} (or a rising edge of the start signal V_{START}) and a time point of a rising edge of the determination signal V_{STOP}. The TDC 650 may further comprise a counter 652, where the counter 652 is coupled to an output terminal of the AND gate 651. In this embodiment, the counter 652 is configured to generate a counting result such as entropy data {BOUT[0], BOUT[1],..., BOUT[N - 1], BOUT[N]} according to the counting clock, where the counting result may indicate a number of times of the counting clock toggling within the time interval. For example, the counter 652 may comprise multiple flip-flops such as DFFs DFF₀, DFF₁, ..., DFF_{(N - 1)} and DFF_{N}, where each DFF of the DFFs DFF₀, DFF₁, ..., DFF_{(N - 1)} and DFF_{N} may comprise a data input terminal (labeled "D" in FIG. 6), a data output terminal (labeled "Q" in FIG. 6), an inverted data output terminal (labeled "QB" in FIG. 6), a clock terminal (illustrated by a triangle in FIG. 6) and a reset terminal (labeled "RST" in FIG. 6). As shown in FIG. 6, the clock terminal of the DFF DFF₀ is coupled to the output terminal of the AND gate 651, and the inverted data output terminal of the DFF DFF₀ is coupled to the data input terminal of the DFF₀. The clock terminal of the DFF DFF₁ is coupled to the inverted data output terminal of the DFF DFF₀, and the inverted data output terminal of the DFF DFF₁ is coupled to the data input terminal of the DFF₁. The rest may be deduced by analogy, where the clock terminal of the DFF DFF_{N} is coupled to the inverted data output terminal of the DFF DFF_{(N - 1)}, and the inverted data output terminal of the DFF DFF_{N} is coupled to the data input terminal of the DFF_{N}. In addition, the reset terminals of the DFFs DFF₀, DFF₁, ..., DFF_{(N - 1)} and DFF_{N} may receive the flag signal VALID, and the data output terminals of the DFFs DFF₀, DFF₁, ..., DFF_{(N - 1)} and DFF_{N} may output the entropy data {BOUT[0], BOUT[1],..., BOUT[N - 1], BOUT[N]}, where a value of the entropy data {BOUT[0], BOUT[1],..., BOUT[N - 1], BOUT[N]} is expressed in a format of a binary code. In addition, a frequency of the TDC clock f_clk may be greater than a frequency of the system clock CLK_{SYS}, where resolution of the TDC 650 may be determined by the frequency of the TDC clock f_clk.

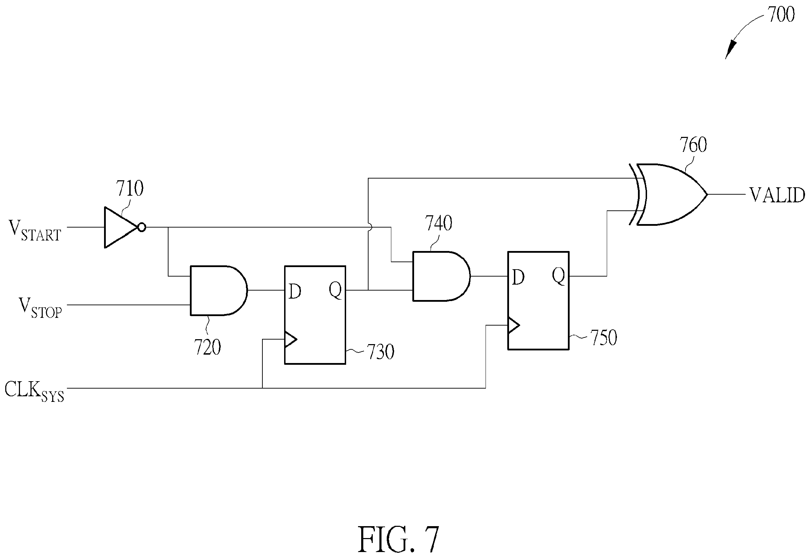

FIG. 7 is a diagram illustrating a flag signal generator 700 according to an embodiment of the present invention, where any of the entropy source circuit 10 shown in FIG. 1, the entropy source circuit 30 shown in FIG. 3 and the entropy source circuit 40 shown in FIG. 4 may comprise the flag signal generator 700 (e.g. the TDC 150 may comprise the flag signal generator 700). In this embodiment, the flag signal generator 700 may be configured to generate the flag signal VALID according to the system clock CLK_{SYS}, the start signal V_{START} and the determination signal V_{STOP}, to indicate whether the entropy data D_{TDC} (or the entropy data D_{OUT}) is valid. Under a condition of the flag signal VALID being a first logic value (e.g. the logic value "0"), the start signal V_{START} being the first logic value and the determination signal being the second logic value (e.g. the logic value "1"), the flag signal VALID may be pulled to the second logic value at a time point of a next rising edge of the system clock CLK_{SYS}. Under a condition of the flag signal VALID being the second logic value and the determination signal V_{STOP} being the second logic value, the flag signal VALID may be pulled to the first logic value at a time point of the next rising edge of the system clock CLK_{SYS}.

As shown in FIG. 7, the flag signal generator 700 may comprise an inverter 710, a first AND gate such as an AND gate 720, a first flip-flop such as a DFF 730, a second AND gate such as an AND gate 740, a second flip-flop such as a DFF 750, and an XOR gate 760. In this embodiment, the inverter 710 may be configured to receive the start signal V_{START}. A first input terminal of the AND gate 720 is coupled to an output terminal of the inverter 710, and a second input terminal of the AND gate 720 is configured to receive the determination signal V_{STOP}. A data input terminal (labeled "D" in FIG. 7) of the DFF 730 is coupled to an output terminal of the AND gate 720, and a clock terminal (illustrated by a triangle in FIG. 7) of the DFF 730 is configured to receive the system clock CLK_{SYS}. A first input terminal of the AND gate 740 is coupled to the output terminal of the inverter 710, and a second input terminal of the AND gate 740 is coupled to a data output terminal (labeled "Q" in FIG. 7) of the DFF 730. A data input terminal (labeled "D" in FIG. 7) of the DFF 750 is coupled to an output terminal of the AND gate 740, and a clock terminal (illustrated by a triangle in FIG. 7) of the DFF 750 is configured to receive the system clock CLK_{SYS}. Two input terminals of the XOR gate 760 are respectively coupled to data output terminals (labeled "Q" in FIG. 7) of the DFF 730 and the DFF 750, and the XOR gate 760 may be configured to perform an XOR logic operation on an output of the DFF 730 and an output of the DFF 750, in order to generate the flag signal VALID.

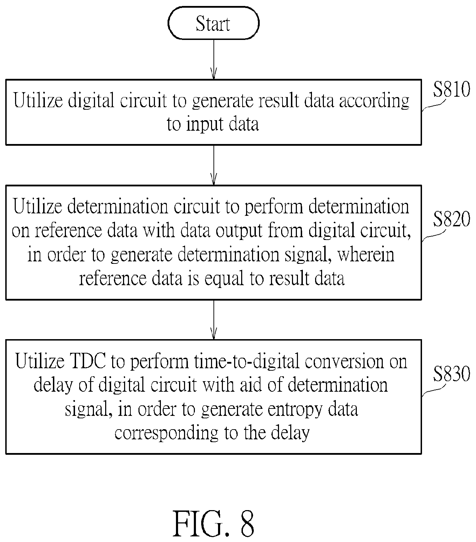

FIG. 8 is a diagram illustrating a working flow of a method for collecting randomness from operation time of a digital circuit according to an embodiment of the present invention, where the method is applicable to an entropy source circuit such as the entropy source circuit 10 shown in FIG. 1, the entropy source circuit 30 shown in FIG. 3 and the entropy source circuit 40 shown in FIG. 4, and the entropy source circuit may comprise the digital circuit. It should be noted that the working flow shown in FIG. 8 is for illustrative purposes only, and is not meant to be a limitation of the present invention. More particularly, one or more steps may be added, deleted or modified in the working flow shown in FIG. 8. In addition, if an overall result is not hindered, these steps do not have to be executed in the exact order shown in FIG. 8.

In Step S810, the entropy source circuit may utilize the digital circuit (e.g. the combinational logic circuit 130) to generate a result data according to an input data.

In Step S820, the entropy source circuit may utilize a determination circuit (e.g. the comparator 140) to perform determination on reference data with data output from the digital circuit, in order to generate a determination signal, wherein the reference data is equal to the result data.

In Step S830, the entropy source circuit may utilize a TDC (e.g. the TDC 150) to perform time-to-digital conversion on a delay of the digital circuit (e.g. the delay for generating the result data according to the input data spent by the digital circuit) with aid of the determination signal, in order to generate entropy data such as an entropy value corresponding to the delay.

To summarize, the entropy source circuit and the method provided by the embodiments of the present invention can generate entropy data by collecting randomness from operation time of a combinational logic circuit, and the design of the entropy source circuit can be integrated into a digital design flow. Thus, efficiency of an overall design flow can be effectively improved. In addition, the embodiment of the present invention will not greatly increase additional costs. Thus, the present invention can improve the efficiency of the overall design flow without introducing any side effect or in a way that is less likely to introduce side effects.

## Claims

1. An entropy source circuit (10, 30, 40), comprising:
an input data control circuit (110), configured to output a start signal, input data, and reference data corresponding to the input data;
a digital circuit (130), having an input terminal and an output terminal, wherein the input terminal of the digital circuit (130) is configured to receive the input data and the output terminal of the digital circuit (130) is configured to output result data equal to the reference data according to the input data, wherein the reference data is a constant value while the result data is generated;
a determination circuit (140), coupled to the output terminal of the digital circuit (130), configured to receive the reference data, wherein when the result data is generated on the output terminal of the digital circuit (130), the determination circuit (140) generates a determination signal based on the reference data and the result data, wherein the reference data is transmitted to the determination circuit (140) before the result data is outputted from the digital circuit (130); and
a time-to-digital converter (150), coupled to the input data control circuit (110) and the determination circuit (140), configured to receive the start signal and generate entropy data according to the start signal and the determination signal.

2. The entropy source circuit (10, 30, 40) of claim 1, wherein the digital circuit (130) receives the input data at a first time point, and the result data is generated on the output terminal of the digital circuit (130) at a second time point, wherein a time difference between the first time point and the second time point corresponds to the entropy data.

3. The entropy source circuit (10, 30, 40) of claim 2, wherein the first time point is indicated by the start signal, and the second time point is indicated by the determination signal.

4. The entropy source circuit (40) of claim 1, wherein the input data control circuit (110) comprises:
an AND gate (118), configured to perform an AND logic operation on an external control signal and a system clock, in order to generate the start signal;
a flip-flop (116), configured to control timing of updating the input data and the reference data according to the start signal; and
an inverter (117), wherein an input terminal of the inverter (117) is coupled to an output terminal of the flip-flop (116), and an output terminal of the inverter (117) is coupled to an input terminal of the flip-flop (116) and the digital circuit (130);
wherein a logic value of the output terminal of the inverter (117) represents the input data and the reference data.

5. The entropy source circuit (40) of claim 4, wherein the digital circuit (130) comprises:
multiple delay units connected in series (D1, D2, DN), wherein an input terminal of a first delay unit (D1) of the multiple delay units is coupled to the output terminal of the inverter (117), and an output terminal of a last delay unit (DN) of the multiple delay units is coupled to the determination circuit (140).

6. The entropy source circuit (40) of claim 5, wherein the determination circuit (140) comprises:
an exclusive-OR gate (141), wherein a first input terminal of the exclusive-OR gate (141) is coupled to the output terminal of the last delay unit, and a second input terminal of the exclusive-OR gate (141) is coupled to the output terminal of the inverter;
wherein a logic value of an output terminal of the exclusive-OR gate (141) represents the determination signal.

7. The entropy source circuit (30) of claim 1, wherein the input data control circuit (110) comprises:
a first flip-flop (111), configured to control timing of transmitting the input data to the digital circuit (130) according to a system clock;
a second flip-flop (112), configured to control timing of transmitting the start signal to the time-to-digital converter (150) according to the system clock; and
a first selector (113), coupled to the first flip-flop (111), configured to control whether to transmit updated input data to an input terminal of the first flip-flop (111) according to the start signal;
a third flip-flop (114), configured to control timing of transmitting the reference data to the determination circuit (140) according to the system clock; and
a second selector (115), coupled to the third flip-flop (114), configured to control whether to transmit updated reference data to an input terminal of the third flip-flop (114) according to the start signal.

8. The entropy source circuit (30) of claim 7, wherein when the start signal has a first logic value, the first selector (113) transmits output of the first flip-flop (111) to the input terminal of the first flip-flop (111), and the second selector (115) transmits output of the third flip-flop (114) to the input terminal of the third flip-flop (114); and when the start signal has a second logic value, the first selector (113) transmits the updated input data to the input terminal of the first flip-flop (111), and the second selector (115) transmits the updated reference data to the input terminal of the third flip-flop (114).

9. The entropy source circuit (30) of claim 7, wherein the entropy source circuit (30) is coupled to a digital system (50), the digital system (50) comprises a critical path (510), and an input terminal and an output terminal of the critical path (510) are coupled to the first selector (113) and the second selector (115), respectively, wherein a logic operation corresponding to the critical path (510) is equal to a logic operation performed on the input data by the digital circuit (130).

10. The entropy source circuit (30) of claim 9, wherein the updated input data is obtained from the input terminal of the critical path (510), and the updated reference data is obtained from the output terminal of the critical path (510).

11. The entropy source circuit (30) of claim 9, wherein the digital system (50) comprises multiple digital signal paths, and the critical path (510) is a digital signal path having a longest delay among the multiple digital signal paths.

12. The entropy source circuit (10, 30, 40) of claim 1, wherein the time-to-digital converter (150) comprises:
multiple delay units (DS₀, DS₁, DS_{(M-1)}, DS_{M}) connected in series, wherein an input terminal of a first delay unit (DS₀) of the multiple delay units is configured to receive a start signal, and the start signal indicates the first time point; and
multiple flip-flops (DFF₀, DFF₁, DFF_{(M-1)}, DFF_{M}), wherein input terminals of the multiple flip-flops are respectively coupled to output terminals of the multiple delay units, and each flip-flop of the multiple flip-flops transmits data of the input terminal of said each flip-flop to an output terminal of said each flip-flop at the second time point according to the determination signal.

13. The entropy source circuit (10, 30, 40) of claim 1, wherein the time-to-digital converter (150) comprises:
a clock control logic (651), configured to generate a counting clock according to a time-to-digital conversion clock and the determination signal, wherein the counting clock is enabled within a time interval between the first time point and the second time point only; and
a counter (652), coupled to the clock control logic (651), configured to generate a counting result according to the counting clock, wherein the counting result indicates a number of times of the counting clock toggling within the time interval.

14. The entropy source circuit (10, 30, 40) of claim 13, wherein the entropy source circuit (10, 30, 40) further comprises:
a flag signal generator (700), configured to generate a flag signal according to a system clock, a start signal and the determination signal, to indicate whether the entropy data is valid or not, wherein the start signal indicates the first time point;
wherein under a condition of the flag signal being a first logic value, the start signal being the first logic value and the determination signal being a second logic value, the flag signal is pulled to the second logic value at a time point of a next rising edge of the system clock; and under a condition of the flag signal being the second logic value and the determination signal being the second logic value, the flag signal is pulled to the first logic value at a time point of the next rising edge of the system clock.

15. The entropy source circuit (10, 30, 40) of claim 14, wherein the flag signal generator (700) comprises:
an inverter (710), configured to receive the start signal;
a first AND gate (720), wherein a first input terminal of the first AND gate (720) is coupled to an output terminal of the inverter (710), and a second input terminal of the first AND gate (720) is configured to receive the determination signal;
a first flip-flop (730), wherein a data input terminal of the first flip-flop (730) is coupled to an output terminal of the first AND gate (720), and a clock terminal of the first flip-flop (730) is configured to receive the system clock;
a second AND gate (740), wherein a first input terminal of the second AND gate (740) is coupled to the output terminal of the inverter (710), and a second input terminal of the second AND gate (740) is coupled to a data output terminal of the first flip-flop (730);
a second flip-flop (750), wherein a data input terminal of the second flip-flop (750) is coupled to an output terminal of the second AND gate (740), and a clock terminal of the second flip-flop (750) is configured to receive the system clock; and
an exclusive-OR gate (760), coupled to the first flip-flop (730) and the second flip-flop (750), configured to perform an exclusive-OR logic operation on an output of the first flip-flop (730) and an output of the second flip-flop (750), in order to generate the flag signal.

## Patentansprüche

1. Entropiequellen-Schaltung (10, 30, 40), welche umfasst:
eine Eingangsdaten-Steuerschaltung (110), die konfiguriert ist, ein Startsignal, Eingangsdaten und Referenzdaten entsprechend den Eingangsdaten auszugeben;
eine digitale Schaltung (130) mit einem Eingangsanschluss und einem Ausgangsanschluss, wobei der Eingangsanschluss der digitalen Schaltung (130) ausgestaltet ist, die Eingangsdaten zu empfangen, und der Ausgangsanschluss der digitalen Schaltung (130) ausgestaltet ist, den Referenzdaten gleiche Ergebnisdaten, die den Eingangsdaten entsprechen, auszugeben, wobei die Referenzdaten während der Erzeugung der Ergebnisdaten einen konstanten Wert haben;
eine mit dem Ausgangsanschluss der digitalen Schaltung (130) gekoppelte Entscheidungsschaltung (140), die konfiguriert ist, die Referenzdaten zu empfangen, wobei, wenn die Ergebnisdaten am Ausgangsanschluss der digitalen Schaltung (130) erzeugt werden, die Entscheidungsschaltung (140) ein Entscheidungssignal auf der Grundlage der Referenzdaten und der Ergebnisdaten erzeugt, wobei die Referenzdaten an die Entscheidungsschaltung (140) übertragen werden, bevor die Ergebnisdaten von der digitalen Schaltung (130) ausgegeben werden; und
einen Zeit-Digital-Wandler (150), der mit der Eingangsdaten-Steuerschaltung (110) und der Entscheidungsschaltung (140) gekoppelt ist und so konfiguriert ist, dass er das Startsignal empfängt und Entropiedaten entsprechend dem Startsignal und dem Entscheidungssignal erzeugt.

2. Entropiequellen-Schaltung (10, 30, 40) nach Anspruch 1, worin die digitale Schaltung (130) die Eingangsdaten zu einem ersten Zeitpunkt empfängt und die Ergebnisdaten zu einem zweiten Zeitpunkt am Ausgangsanschluss der digitalen Schaltung (130) erzeugt werden, wobei eine Zeitdifferenz zwischen dem ersten Zeitpunkt und dem zweiten Zeitpunkt den Entropiedaten entspricht.

3. Entropiequellen-Schaltung (10, 30, 40) nach Anspruch 2, wobei der erste Zeitpunkt durch das Startsignal und der zweite Zeitpunkt durch das Bestimmungssignal angegeben wird.

4. Entropiequellen-Schaltung (40) nach Anspruch 1, worin die Eingangsdaten-Steuerschaltung (110) umfasst:
ein UND-Gatter (118), das ausgestaltet ist, eine UND-Logikoperation mit einem externen Steuersignal und einem Systemtakt durchzuführen, um das Startsignal zu erzeugen;
ein Flipflop (116), das ausgestaltet ist, den Zeitpunkt der Aktualisierung der Eingangsdaten und der Referenzdaten entsprechend dem Startsignal zu steuern; und
einen Inverter (117), worin ein Eingangsanschluss des Inverters (117) mit einem Ausgangsanschluss des Flipflops (116) gekoppelt ist und ein Ausgangsanschluss des Inverters (117) mit einem Eingangsanschluss des Flipflops (116) und der digitalen Schaltung (130) gekoppelt ist;
wobei ein Logikwert des Ausgangsanschlusses des Inverters (117) die Eingangsdaten und die Referenzdaten darstellt.

5. Entropiequellen-Schaltung (40) nach Anspruch 4, worin die digitale Schaltung (130) umfasst:
mehrere in Reihe geschaltete Verzögerungseinheiten (D1, D2, DN), worin ein Eingangsanschluss einer ersten Verzögerungseinheit (D1) der mehreren Verzögerungseinheiten mit dem Ausgangsanschluss des Inverters (117) gekoppelt ist und ein Ausgangsanschluss einer letzten Verzögerungseinheit (DN) der mehreren Verzögerungseinheiten mit der Bestimmungsschaltung (140) gekoppelt ist.

6. Entropiequellen-Schaltung (40) nach Anspruch 5, worin die Bestimmungsschaltung (140) umfasst:
ein Exklusiv-ODER-Gatter (141), worin ein erster Eingangsanschluss des Exklusiv-ODER-Gatters (141) mit dem Ausgangsanschluss der letzten Verzögerungseinheit gekoppelt ist und ein zweiter Eingangsanschluss des Exklusiv-ODER-Gatters (141) mit dem Ausgangsanschluss des Inverters gekoppelt ist;
wobei ein Logikwert eines Ausgangsanschlusses des Exklusiv-ODER-Gatters (141) das Bestimmungssignal darstellt.

7. Entropiequellen-Schaltung (30) nach Anspruch 1, wobei die Eingangsdaten-Steuerschaltung (110) umfasst:
ein erstes Flipflop (111), das ausgestaltet ist, den Zeitpunkt der Übertragung der Eingangsdaten an die digitale Schaltung (130) entsprechend einem Systemtakt zu steuern;
ein zweites Flipflop (112), das ausgestaltet ist, den Zeitpunkt der Übertragung des Startsignals an den Zeit-Digital-Wandler (150) entsprechend dem Systemtakt zu steuern; und
einen ersten Selektor (113), der mit dem ersten Flipflop (111) gekoppelt und ausgestaltet ist, entsprechend dem Startsignal zu steuern, ob aktualisierte Eingangsdaten an einen Eingangsanschluss des ersten Flipflops (111) übertragen werden sollen;
ein drittes Flipflop (114), das ausgestaltet ist, den Zeitpunkt der Übertragung der Referenzdaten an die Bestimmungsschaltung (140) entsprechend dem Systemtakt zu steuern; und
einen zweiten Selektor (115), der mit dem dritten Flipflop (114) gekoppelt und ausgestaltet ist, entsprechend dem Startsignal zu steuern, ob aktualisierte Referenzdaten an einen Eingangsanschluss des dritten Flipflops (114) übertragen werden sollen.

8. Entropiequellen-Schaltung (30) nach Anspruch 7, wobei, wenn das Startsignal einen ersten Logikwert aufweist, der erste Selektor (113) das Ausgangssignal des ersten Flipflops (111) an den Eingangsanschluss des ersten Flipflops (111) weiterleitet und der zweite Selektor (115) das Ausgangssignal des dritten Flipflops (114) an den Eingangsanschluss des dritten Flipflops (114) weiterleitet; und wenn das Startsignal einen zweiten Logikwert aufweist, der erste Selektor (113) die aktualisierten Eingangsdaten an den Eingangsanschluss des ersten Flipflops (111) weiterleitet, und der zweite Selektor (115) die aktualisierten Referenzdaten an den Eingangsanschluss des dritten Flipflops (114) leitet.

9. Entropiequellen-Schaltung (30) nach Anspruch 7, worin die Entropiequellen-Schaltung (30) mit einem digitalen System (50) gekoppelt ist, das digitale System (50) einen kritischen Pfad (510) umfasst, und ein Eingangsanschluss sowie ein Ausgangsanschluss des kritischen Pfads (510) jeweils mit dem ersten Selektor (113) und dem zweiten Selektor (115) gekoppelt sind, wobei eine dem kritischen Pfad (510) entsprechende logische Operation gleich einer logischen Operation ist, die von der digitalen Schaltung (130) an den Eingangsdaten durchgeführt wird.

10. Entropiequellen-Schaltung (30) nach Anspruch 9, wobei die aktualisierten Eingangsdaten vom Eingangsanschluss des kritischen Pfads (510) und die aktualisierten Referenzdaten vom Ausgangsanschluss des kritischen Pfads (510) erhalten werden.

11. Entropiequellen-Schaltung (30) nach Anspruch 9, worin das digitale System (50) mehrere digitale Signalpfade umfasst und der kritische Pfad (510) ein digitaler Signalpfad ist, der unter den mehreren digitalen Signalpfaden die größte Verzögerung aufweist.

12. Entropiequellen-Schaltung (10, 30, 40) nach Anspruch 1, wobei der Zeit-Digital-Wandler (150) umfasst:
mehrere in Reihe geschaltete Verzögerungseinheiten (DS0, DS1, DS(M-1), DSM), worin ein Eingangsanschluss einer ersten Verzögerungseinheit (DS0) der mehreren Verzögerungseinheiten ausgestaltet ist, ein Startsignal zu empfangen, und wobei das Startsignal den ersten Zeitpunkt angibt; und
mehrere Flipflops (DFF0, DFF1, DFF(M-1), DFFM), worin die Eingangsanschlüsse der mehreren Flipflops jeweils mit den Ausgangsanschlüssen der mehreren Verzögerungseinheiten gekoppelt sind und jedes Flipflop der mehreren Flipflops Daten vom Eingangsanschluss des jeweiligen Flipflops zum zweiten Zeitpunkt gemäß dem Bestimmungssignal an einen Ausgangsanschluss des jeweiligen Flipflops überträgt.

13. Entropiequellen-Schaltung (10, 30, 40) nach Anspruch 1, wobei der Zeit-Digital-Wandler (150) umfasst:
eine Taktsteuerlogik (651), die ausgestaltet ist, einen Zähltakt entsprechend einem Zeit-Digital-Wandlungstakt und dem Bestimmungssignal zu erzeugen, wobei der Zähltakt nur innerhalb eines Zeitintervalls zwischen dem ersten Zeitpunkt und dem zweiten Zeitpunkt freigegeben wird; und
einen Zähler (652), der mit der Taktsteuerlogik (651) gekoppelt und ausgestaltet ist, entsprechend dem Zähltakt ein Zählergebnis zu erzeugen, worin das Zählergebnis die Anzahl der Taktwechsel des Zähltakts innerhalb des Zeitintervalls angibt.

14. Entropiequellen-Schaltung (10, 30, 40) nach Anspruch 13, worin die Entropiequellen-Schaltung (10, 30, 40) ferner umfasst:
einen Flag-Signalgenerator (700), der ausgestaltet ist, ein Flag-Signal entsprechend einem Systemtakt, einem Startsignal und dem Bestimmungssignal zu erzeugen, um anzuzeigen, ob die Entropiedaten gültig sind oder nicht, wobei das Startsignal den ersten Zeitpunkt angibt;
wobei unter der Bedingung, dass das Flag-Signal einen ersten Logikwert annimmt, das Startsignal den ersten Logikwert annimmt und das Bestimmungssignal einen zweiten Logikwert annimmt, das Flag-Signal zu einem Zeitpunkt der nächsten steigenden Flanke des Systemtakts auf den zweiten Logikwert gesetzt wird; und unter der Bedingung, dass das Flag-Signal den zweiten Logikwert annimmt und das Bestimmungssignal den zweiten Logikwert annimmt, das Flag-Signal zu einem Zeitpunkt der nächsten steigenden Flanke des Systemtakts auf den ersten Logikwert gesetzt wird.

15. Entropiequellen-Schaltung (10, 30, 40) nach Anspruch 14, wobei der Flag-Signalgenerator (700) umfasst:
einen Inverter (710), der ausgestaltet ist, das Startsignal zu empfangen;
ein erstes UND-Gatter (720), worin ein erster Eingangsanschluss des ersten UND-Gatters (720) mit einem Ausgangsanschluss des Inverters (710) gekoppelt ist und ein zweiter Eingangsanschluss des ersten UND-Gatters (720) ausgestaltet ist, das Bestimmungssignal zu empfangen;
ein erstes Flipflop (730), wobei ein Dateneingangsanschluss des ersten Flipflops (730) mit einem Ausgangsanschluss des ersten UND-Gatters (720) gekoppelt ist und ein Taktanschluss des ersten Flipflops (730) ausgestaltet ist, den Systemtakt zu empfangen;
ein zweites UND-Gatter (740), wobei ein erster Eingangsanschluss des zweiten UND-Gatters (740) mit dem Ausgangsanschluss des Inverters (710) gekoppelt ist und ein zweiter Eingangsanschluss des zweiten UND-Gatters (740) mit einem Datenausgangsanschluss des ersten Flipflops (730) gekoppelt ist;
ein zweites Flipflop (750), wobei ein Dateneingangsanschluss des zweiten Flipflops (750) mit einem Ausgangsanschluss des zweiten UND-Gatters (740) gekoppelt ist und ein Taktanschluss des zweiten Flipflops (750) ausgestaltet ist, den Systemtakt zu empfangen; und
ein Exklusiv-ODER-Gatter (760), das mit dem ersten Flipflop (730) und dem zweiten Flipflop (750) gekoppelt und ausgestaltet ist, eine Exklusiv-ODER-Logikoperation an einem Ausgang des ersten Flipflops (730) und einem Ausgang des zweiten Flipflops (750) durchzuführen, um das Flag-Signal zu erzeugen.

## Revendications

1. Circuit de source d'entropie (10, 30, 40), comprenant:
un circuit de commande des données d'entrée (110), configuré pour délivrer un signal de démarrage, des données d'entrée et des données de référence correspondant aux données d'entrée;
un circuit numérique (130), comportant une borne d'entrée et une borne de sortie, dans lequel la borne d'entrée du circuit numérique (130) est configurée pour recevoir les données d'entrée et la borne de sortie du circuit numérique (130) est configurée pour délivrer des données de résultat égales aux données de référence en fonction des données d'entrée, les données de référence étant une valeur constante pendant la génération des données de résultat;
un circuit de détermination (140), couplé à la borne de sortie du circuit numérique (130), configuré pour recevoir les données de référence, dans lequel, lorsque les données de résultat sont générées sur la borne de sortie du circuit numérique (130), le circuit de détermination (140) génère un signal de détermination sur la base des données de référence et des données de résultat, les données de référence étant transmises au circuit de détermination (140) avant que les données de résultat ne soient émises par le circuit numérique (130); et
un convertisseur temps-numérique (150), couplé au circuit de commande des données d'entrée (110) et au circuit de détermination (140), configuré pour recevoir le signal de démarrage et générer des données d'entropie en fonction du signal de démarrage et du signal de détermination.

2. Circuit de source d'entropie (10, 30, 40) selon la revendication 1, dans lequel le circuit numérique (130) reçoit les données d'entrée à un premier instant, et les données de résultat sont générées sur la borne de sortie du circuit numérique (130) à un deuxième instant, la différence de temps entre le premier instant et le deuxième instant correspondant aux données d'entropie.

3. Circuit de source d'entropie (10, 30, 40) selon la revendication 2, dans lequel le premier instant est indiqué par le signal de démarrage, et le deuxième instant est indiqué par le signal de détermination.

4. Circuit de source d'entropie (40) selon la revendication 1, dans lequel le circuit de commande des données d'entrée (110) comprend:
une porte ET (118), configurée pour effectuer une opération logique ET sur un signal de commande externe et une horloge système, afin de générer le signal de démarrage;
une bascule (116), configurée pour contrôler la synchronisation de la mise à jour des données d'entrée et des données de référence en fonction du signal de démarrage; et
un inverseur (117), dans lequel une borne d'entrée de l'inverseur (117) est couplée à une borne de sortie de la bascule (116), et une borne de sortie de l'inverseur (117) est couplée à une borne d'entrée de la bascule (116) et au circuit numérique (130);
dans lequel une valeur logique de la borne de sortie de l'inverseur (117) représente les données d'entrée et les données de référence.

5. Circuit de source d'entropie (40) selon la revendication 4, dans lequel le circuit numérique (130) comprend:
plusieurs unités de retard connectées en série (D1, D2, DN), dans lequel une borne d'entrée d'une première unité de retard (D1) parmi lesdites plusieurs unités de retard est couplée à la borne de sortie de l'inverseur (117), et une borne de sortie d'une dernière unité de retard (DN) parmi lesdites plusieurs unités de retard est couplée au circuit de détermination (140).

6. Circuit de source d'entropie (40) selon la revendication 5, dans lequel le circuit de détermination (140) comprend:
une porte OU exclusif (141), dans laquelle une première borne d'entrée de la porte OU exclusif (141) est couplée à la borne de sortie de la dernière unité de retard, et une deuxième borne d'entrée de la porte OU exclusif (141) est couplée à la borne de sortie de l'inverseur;
dans lequel une valeur logique d'une borne de sortie de la porte OU exclusif (141) représente le signal de détermination.

7. Circuit de source d'entropie (30) selon la revendication 1, dans lequel le circuit de commande des données d'entrée (110) comprend:
une première bascule (111), configurée pour commander la synchronisation de la transmission des données d'entrée vers le circuit numérique (130) en fonction d'une horloge système;
une deuxième bascule (112), configurée pour commander la synchronisation de la transmission du signal de démarrage au convertisseur temps-numérique (150) en fonction de l'horloge système; et
un premier sélecteur (113), couplé à la première bascule (111), configuré pour déterminer s'il convient de transmettre des données d'entrée mises à jour à une borne d'entrée de la première bascule (111) en fonction du signal de démarrage;
une troisième bascule (114), configurée pour commander le moment de la transmission des données de référence au circuit de détermination (140) en fonction de l'horloge système; et
un deuxième sélecteur (115), couplé à la troisième bascule (114), configuré pour déterminer s'il convient de transmettre des données de référence mises à jour à une borne d'entrée de la troisième bascule (114) en fonction du signal de démarrage.

8. Circuit de source d'entropie (30) selon la revendication 7, dans lequel, lorsque le signal de démarrage a une première valeur logique, le premier sélecteur (113) transmet la sortie de la première bascule (111) à la borne d'entrée de la première bascule (111), et le deuxième sélecteur (115) transmet la sortie de la troisième bascule (114) à la borne d'entrée de la troisième bascule (114); et lorsque le signal de démarrage a une deuxième valeur logique, le premier sélecteur (113) transmet les données d'entrée mises à jour à la borne d'entrée de la première bascule (111), et le deuxième sélecteur (115) transmet les données de référence mises à jour à la borne d'entrée de la troisième bascule (114).

9. Circuit de source d'entropie (30) selon la revendication 7, dans lequel le circuit de source d'entropie (30) est couplé à un système numérique (50), le système numérique (50) comprend un chemin critique (510), et une borne d'entrée et une borne de sortie du chemin critique (510) sont couplées respectivement au premier sélecteur (113) et au deuxième sélecteur (115), dans lequel une opération logique correspondant au chemin critique (510) est égale à une opération logique effectuée sur les données d'entrée par le circuit numérique (130).

10. Circuit de source d'entropie (30) selon la revendication 9, dans lequel les données d'entrée mises à jour sont obtenues à partir de la borne d'entrée du chemin critique (510), et les données de référence mises à jour sont obtenues à partir de la borne de sortie du chemin critique (510).

11. Circuit de source d'entropie (30) selon la revendication 9, dans lequel le système numérique (50) comprend plusieurs chemins de signaux numériques, et le chemin critique (510) est un chemin de signaux numériques présentant le délai le plus long parmi lesdits plusieurs chemins de signaux numériques.

12. Circuit de source d'entropie (10, 30, 40) selon la revendication 1, dans lequel le convertisseur temps-numérique (150) comprend:
plusieurs unités de retard (DS0, DS1, DS(M-1), DSM) connectées en série, dans lequel une borne d'entrée d'une première unité de retard (DS0) parmi lesdites plusieurs unités de retard est configurée pour recevoir un signal de démarrage, et ledit signal de démarrage indique le premier instant; et
plusieurs bascules (DFF0, DFF1, DFF(M-1), DFFM), les bornes d'entrée des plusieurs bascules étant respectivement couplées aux bornes de sortie des unités de retard, et chaque bascule des plusieurs bascules transmettant les données de sa borne d'entrée de chaque bascule à la borne de sortie de chaque bascule au deuxième instant, conformément au signal de détermination.

13. Circuit de source d'entropie (10, 30, 40) selon la revendication 1, dans lequel le convertisseur temps-numérique (150) comprend:
une logique de commande d'horloge (651), configurée pour générer une horloge de comptage en fonction d'une horloge de conversion temps-numérique et du signal de détermination, l'horloge de comptage n'étant activée que pendant un intervalle de temps compris entre le premier instant et le deuxième instant; et
un compteur (652), couplé à la logique de commande d'horloge (651), configuré pour générer un résultat de comptage en fonction de l'horloge de comptage, le résultat de comptage indiquant le nombre de fois où l'horloge de comptage a basculé au cours de cet intervalle de temps.

14. Circuit de source d'entropie (10, 30, 40) selon la revendication 13, dans lequel le circuit de source d'entropie (10, 30, 40) comprend en outre:
un générateur de signal d'indicateur (700), configuré pour générer un signal d'indicateur en fonction d'une horloge système, d'un signal de démarrage et du signal de détermination, afin d'indiquer si les données d'entropie sont valides ou non, le signal de démarrage indiquant le premier instant;
dans lequel, lorsque le signal d'indicateur prend une première valeur logique, que le signal de démarrage prend la première valeur logique et que le signal de détermination prend une deuxième valeur logique, le signal d'indicateur est amené à la deuxième valeur logique à l'instant du prochain front montant de l'horloge système; et lorsque le signal d'indicateur prend la deuxième valeur logique et que le signal de détermination prend la deuxième valeur logique, le signal d'indicateur est ramené à la première valeur logique à un instant du front montant suivant de l'horloge système.

15. Circuit de source d'entropie (10, 30, 40) selon la revendication 14, dans lequel le générateur de signal d'indicateur (700) comprend:
un inverseur (710), configuré pour recevoir le signal de démarrage;
une première porte ET (720), dans laquelle une première borne d'entrée de la première porte ET (720) est couplée à une borne de sortie de l'inverseur (710), et une deuxième borne d'entrée de la première porte ET (720) est configurée pour recevoir le signal de détermination;
une première bascule (730), dans laquelle une borne d'entrée de données de la première bascule (730) est couplée à une borne de sortie de la première porte ET (720), et une borne d'horloge de la première bascule (730) est configurée pour recevoir l'horloge système;
une deuxième porte ET (740), dans laquelle une première borne d'entrée de la deuxième porte ET (740) est couplée à la borne de sortie de l'inverseur (710), et dont une deuxième borne d'entrée de la deuxième porte ET (740) est couplée à une borne de sortie de données de la première bascule (730);
une deuxième bascule (750), dont une borne d'entrée de données de la deuxième bascule (750) est couplée à une borne de sortie de la deuxième porte ET (740), et dont une borne d'horloge de la deuxième bascule (750) est configurée pour recevoir l'horloge système; et
une porte OU exclusif (760), couplée à la première bascule (730) et à la deuxième bascule (750), configurée pour effectuer une opération logique OU exclusif sur une sortie de la première bascule (730) et une sortie de la deuxième bascule (750), afin de générer le signal d'indicateur.
